# EUROPÄISCHE PATENTANMELDUNG

(11) **EP 1 635 395 A2**
(43) Veröffentlichungstag der Anmeldung: **15.03.2006**
(21) Anmeldenummer: 05019481.0
(22) Anmeldetag: 07.09.2005
(51) Int. Cl.: H01L 27/115, H01L 21/8246, H01L 21/336, H01L 29/792, H01L 29/78

(54) **Charge-trapping-Halbleiterspeicherbauelement mit Ladungshaftstellen-Speicherzellen**

(30) Priorität: 14.09.2004 US 940414; 30.09.2004 DE 102004047655
(71) Anmelder: Infineon Technologies AG, 81669 München (DE)
(72) Erfinder: Verhoeven, Martin, 01445 Radebeul (DE)
(74) Vertreter: Epping - Hermann - Fischer

(57) **Zusammenfassung**

Speicherzellen sind an der Hauptfläche eines Halbleitersubstrats (1) durch vorzugsweise zylindrische Vertiefungen (2) ausgebildet, die eine Speicherschichtfolge (3) an Seitenwänden und eine Gateelektrode (4) enthalten und mit oberen (5) und unteren Source-/Draingebieten (6) versehen sind, die spaltenweise mit ersten und zweiten Bitleitungen (8, 9) verbunden sind. Wortleitungen (10) sind über den ersten und zweiten Bitleitungen angeordnet und mit Zeilen von Gateelektroden verbunden. Die vertikale Transistorstruktur ermöglicht ein weiteres Schrumpfen der Zellen bei einer erforderlichen minimalen effektiven Kanallänge.

## Beschreibung

Die vorliegende Erfindung betrifft Charge-trapping-Halbleiterspeicherbauelemente, insbesondere Speicherbauelemente, die Arrays von NROM-Zellen umfassen.

Nichtflüchtige Speicherzellen, die elektrisch programmiert und gelöscht werden können, können als Charge-trapping-Speicherzellen realisiert werden, die eine Speicherschichtfolge aus dielektrischen Materialien mit einer Speicherschicht zwischen Begrenzungsschichten aus dielektrischem Material umfassen, die eine größere Energiebandlücke als die Speicherschicht aufweisen. Diese Speicherschichtfolge ist zwischen einem Kanalgebiet in einer Halbleiterschicht oder einem Halbleitersubstrat und einer Gateelektrode angeordnet, die vorgesehen ist, um den Kanal mit Hilfe einer angelegten elektrischen Spannung zu steuern. Das Programmieren der Zelle erfolgt durch das Beschleunigen von Ladungsträgern, insbesondere Elektronen, in dem Kanalgebiet, um Ladungsträger mit ausreichender kinetischer Energie zu erzeugen, die die Begrenzungsschicht durchdringen und in der Speicherschicht eingefangen werden. Source- und Draingebiete sind an beiden Enden des Kanalgebiets zum Anlegen der beschleunigenden elektrischen Spannung vorgesehen. Die Schwellwertspannung der Transistorstruktur wird erfasst, wenn der programmierte Zustand der Speicherzelle gelesen wird. Beispiele für Charge-trapping-Speicherzellen sind die SONOS-Speicherzellen, bei denen jede Begrenzungsschicht ein Oxid des Halbleitermaterials und die Speicherschicht ein Nitrid des Halbleitermaterials, üblicherweise Silizium, ist.

Eine Veröffentlichung von B. Eitan et al., "NROM: a Novel Localized Trapping, 2-Bit Nonvolatile Memory Cell" in IEEE E-lectron Device Letters, Band 21, Seiten 543 bis 545 (2000), beschreibt eine Charge-trapping-Speicherzelle mit einer Speicherschichtfolge aus Oxid, Nitrid und Oxid, die speziell dafür ausgelegt ist, mit einer Lesespannung betrieben zu werden, die umgekehrt zu der programmierenden Spannung ist (reverse read). Die Oxid-Nitrid-Oxid-Schichtfolge ist insbesondere dafür ausgelegt, den Bereich des direkten Tunnelns zu vermeiden und den Erhalt der eingefangenen Ladungsträger in vertikaler Richtung zu garantieren. Für die Oxidschichten ist eine Dicke von über 5 nm angegeben.

Die Speicherschicht kann durch ein anderes dielektrisches Material ersetzt werden, vorausgesetzt, die Energiebandlücke ist kleiner als die Energiebandlücke der Begrenzungsschichten. Die Differenz der Energiebandlücken sollte so groß wie möglich sein, um eine gute Ladungsträgerbegrenzung und somit einen guten Datenerhalt sicherzustellen. Wenn Siliziumdioxid als Begrenzungsschichten verwendet wird, kann die Speicherschicht Tantaloxid, Kadmiumsilikat, Titanoxid, Zirkoniumoxid oder Aluminiumoxid sein. Als das Material der Speicherschicht kann auch intrinsisch leitendes (nichtdotiertes) Silizium verwendet werden.

Mit der standardmäßigen planaren NROM-Zelle können durch das Anlegen gegensinniger Betriebsspannungen Bits an beiden Kanalenden gespeichert werden. Dies bedeutet, dass in jede Speicherzelle zwei Bits programmiert werden können. Die Trennung der beiden Bits wird jedoch immer schwieriger, sowie sich die Stellen für die Ladungsspeicherung wegen der Reduzierung der Zellenabmessungen stark annähern, was der Skalierbarkeit der planaren NROM-Zelle Einschränkungen auferlegt.

Die weitere Miniaturisierung von Halbleiterspeicherbauelementen, die Charge-trapping-Zellen umfassen, ist wegen der erforderlichen kleinsten effektiven Kanallänge begrenzt. Um dieses Problem zu beseitigen, sind Speicherzellen vorgeschlagen worden, die an Seitenwänden von Gräben angeordnet sind. Die Gateelektrode ist so innerhalb des Grabens angeordnet, dass ein Kanal, der sich entlang der Seitenwand und/oder dem Boden des Grabens erstreckt, gesteuert werden kann. Source- und Draingebiete sind an der oberen Oberfläche des Bauelements neben den Gräben oder sowohl an der oberen Oberfläche als auch an einem Bodengebiet der Gräben angeordnet. Die Grabentransistorstruktur eignet sich somit dafür, den erforderlichen Flächeninhalt des Speicherzellenarrays erheblich zu reduzieren.

Aufgabe der vorliegenden Erfindung ist es, ein Charge-trapping-Halbleiterspeicherbauelement mit Speicherzellen anzugeben, die eine verbesserte Zwei-Bit-Trennung aufweisen und in einem Speicherzellenarray mit extrem reduzierter Fläche angeordnet sein können. Die Speicherzellen sollen insbesondere NROM-Zellen sein, die für das Programmieren von zwei oder mehr Bits vorgesehen sind.

Diese Aufgabe wird mit dem Charge-trapping-Halbleiterspeicherbauelement mit den Merkmalen des Anspruches 1 gelöst. Ausgestaltungen ergeben sich aus den abhängigen Ansprüchen.

Standard-Halbleitertechnologie ist ausreichend, um Ausführungsformen von Charge-trapping-Speicherbauelementen gemäßder vorliegenden Erfindung herzustellen.

Dieses Speicherbauelement umfasst Speicherzellen, die durch Vertiefungen an einer Hauptfläche einer Halbleiterschicht oder eines Substrats ausgebildet sind. Diese Vertiefungen, die bevorzugt zylindrisch sind, sind auf ihren Seitenwänden mit einer Speicherschichtfolge versehen. Das Innere der Vertiefungen ist mit einem elektrisch leitenden Material gefüllt, das die Gateelektroden bildet. Das Halbleitermaterial neben dem oberen Teil und dem unteren Teil der Vertiefungen ist zur Ausbildung von Source- und Draingebieten dotiert. Die unteren Source-/Draingebiete, die an die Böden der Vertiefungen angrenzen, können durch Kontaktplugs kontaktiert werden, die einen elektrischen Anschluss der unteren Source-/Draingebiete durch Leiterbahnen von Verdrahtungsschichten gestatten. Die oberen Source-/Draingebiete umgeben vorzugsweise den oberen Teil der Vertiefungen und sind oberhalb durch Bereiche der Hauptfläche der Halbleiterschicht oder des Substrats begrenzt, wo die entsprechende Bitleitung kontaktiert werden kann.

Auf diese Weise können Spalten oberer Source-/Draingebiete und Spalten unterer Source-/Draingebiete elektrisch mit Bitleitungen verbunden werden, die parallel zueinander an der oberen Oberfläche des Bauelements angeordnet sind. Die Bitleitungen werden von Wortleitungen gekreuzt, die parallel zueinander angeordnet und elektrisch von den Bitleitungen isoliert sind und die Reihen von Gateelektroden der Speicherzellen verbinden. Die Speicherschichtfolge ist zumindest neben den Source-/Draingebieten vorgesehen, so dass Informationsbits an beiden Enden des Kanalgebiets gespeichert werden können, das in dem Halbleitermaterial der bevorzugt zylindrischen Seitenwand der Vertiefung ausgebildet ist.

Es folgt eine genauere Beschreibung von Beispielen des Charge-trapping-Halbleiterspeicherbauelementes anhand der beigefügten Figuren.

Figur 1 zeigt einen schematischen Querschnitt durch einen Teil einer bevorzugten Ausführungsform des Halbleiterspeicherbauelements, einschließlich Abschnitten von Bitleitungen und Wortleitungen.

Figur 2 zeigt eine Draufsicht auf ein Ausführungsbeispiel des Bauelements, die die Anordnung aus Vertiefungen, Gateelektroden, Bitleitungen und Wortleitungen zeigt.

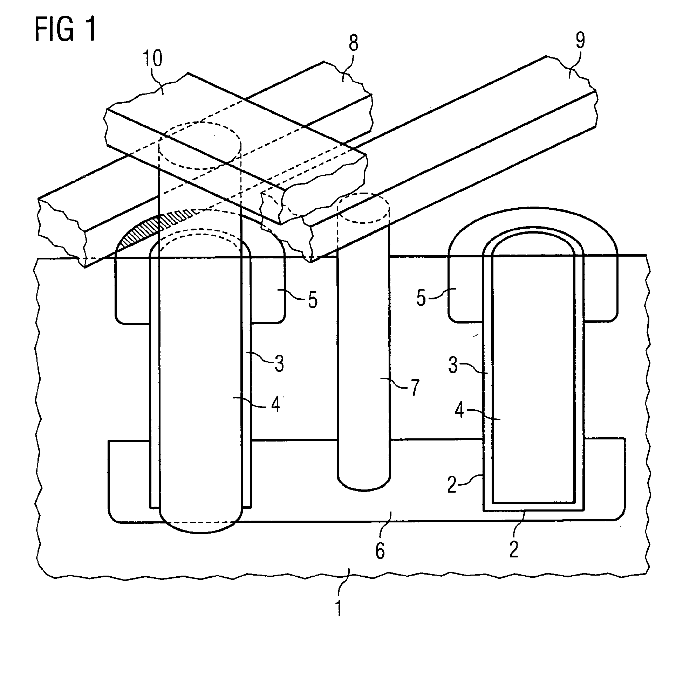

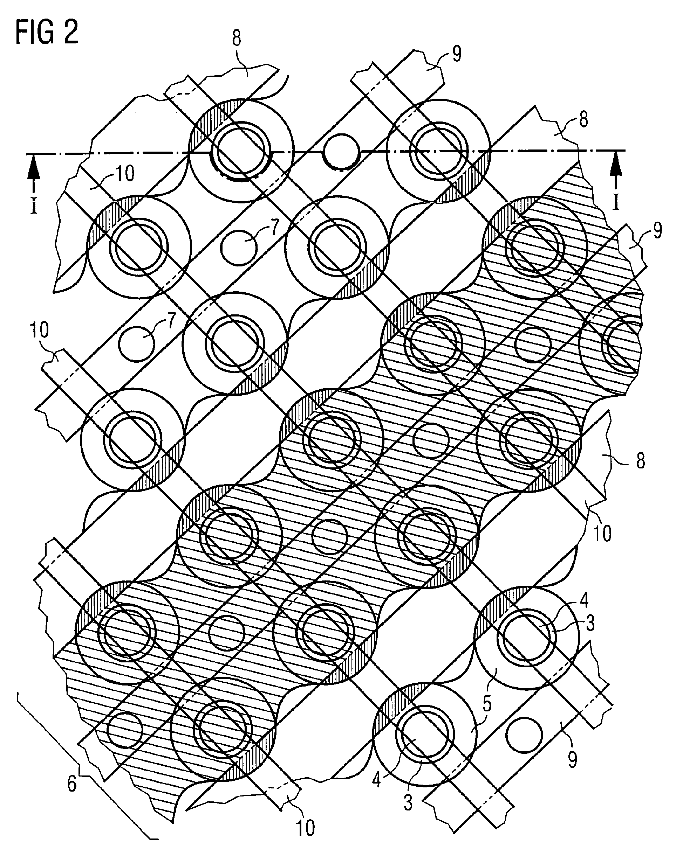

Das Charge-trapping-Halbleiterspeicherbauelement umfasst eine Halbleiterschicht oder ein Substrat mit einer Hauptfläche, in der vorzugsweise durch ein Ätzverfahren Vertiefungen ausgebildet worden sind. Diese Vertiefungen dienen als Orte einzelner Speicherzellen, die jeweils eine Transistorstruktur und eine Speicherschichtfolge umfassen. Figur 1 zeigt einen Querschnitt durch ein Substrat 1 aus Halbleitermaterial, vorzugsweise Silizium, in das zylindrische Vertiefungen 2 geätzt worden sind. Die idealisierte Zeichnung von Figur 1 zeigt zwei Vertiefungen mit zylindrischer Form mit flachen Bodenbereichen. Gemäß standardmäßigen Ätzverfahren wird erwartet, dass praktische Ausführungsformen des Bauelements mit Vertiefungen realisiert werden, die abgerundete oder verjüngte Böden aufweisen. Jedenfalls gibt es keine Einschränkung hinsichtlich der geometrischen Form der Vertiefungen. Die Vertiefungen sind bevorzugt Zylinder, doch kann die tatsächliche Form von der idealen Zylinderform abweichen. Seitenwände der Vertiefungen sind mit der Speicherschichtfolge 3 bedeckt, die zumindest in Bereichen der Seitenwände angeordnet ist, die sich neben den Source-/Draingebieten befinden. Das Innere der Vertiefungen ist mit dem Material der Gateelektroden 4 gefüllt. Die zylindrische Form der Gateelektrode 4 ist auf der linken Seite von Figur 1 angedeutet, die eine Gateelektrode in dreidimensionaler Perspektive zeigt. Dies wird in Verbindung mit Figur 2 näher erläutert.

Figur 1 zeigt auch die Stelle der oberen Source-/Draingebiete 5 und der unteren Source-/Draingebiete 6, die durch dotierte Gebiete gebildet werden, bei denen es sich um durch wohlbekannte Implantierungsverfahren hergestellte standardmäßige Diffusionsgebiete handeln kann. Bei der Speicherschichtfolge 3 kann es sich um eine beliebige Folge von Materialien handeln, die für die Ausbildung von Charge-trapping-Speicherschichtfolgen geeignet sind, beispielsweise eine Oxid-Nitrid-Oxid-Schichtfolge, bei der die Nitridschicht die Speicherschicht bildet, in der im Verlauf der Programmierung der Zelle Ladungsträger eingefangen werden.

Figur 1 zeigt einen Kontaktplug 7 in dreidimensionaler Perspektive, der das untere Source-/Draingebiet 6 mit Leiterbahnen verbindet, die über der Hauptfläche des Bauelements angeordnet sind. Die Leiterbahnen, die auf dem Bauelement als Mittel zum Adressieren der einzelnen Speicherzellen angeordnet sind, sind an der Oberseite von Figur 1 durch kurze Abschnitte von Bitleitungen und Wortleitungen angedeutet. Es gibt erste Bitleitungen 8, die zum Kontaktieren von Spalten oberer Source-/Draingebiete 5 auf ihrer oberen Oberfläche vorgesehen sind. Dies ist in Figur 1 durch den schraffierten Bereich angedeutet, in dem die obere Oberfläche des linken oberen Source-/Draingebiets 5 sich mit einem Bereich der unteren Oberfläche der ersten Bitleitung 8 in Kontakt befindet. Die unteren Source-/Draingebiete 6 sind elektrisch mit zweiten Bitleitungen 9 verbunden, die bei dieser Ausführungsform über der Hauptfläche des Bauelements angeordnet sind. Die Kontaktplugs 7 sind als eine vertikale elektrische Verbindung zwischen dem unteren Source-/Draingebiet 6 und der unteren Oberfläche der zweiten Bitleitung 9 vorgesehen. Die ersten Bitleitungen 8 und die zweiten Bitleitungen 9 sind parallel zueinander in einer wechselnden Abfolge angeordnet.

Über den Bitleitungen und über die Bitleitungen hinweg befinden sich Wortleitungen 10, die die Gateelektroden 4 in Zeilen von Speicherzellen kontaktieren. Die gestrichelten Linien stellen versteckte Konturen dar, die durch die Wortleitung 10 von oben bedeckt sind. Die in Figur 1 gezeichnete linke Gateelektrode ist in perspektivischer Ansicht gezeigt. Der obere kreisförmige Bereich der Gateelektrode 4, der in der perspektivischen Ansicht als eine Ellipse dargestellt ist, wird von der Wortleitung 10 kontaktiert.

Die Leiterbahnen sind in drei verschiedenen Verdrahtungsschichten auf unterschiedlichen Höhen über der Hauptfläche des Bauelements angeordnet. Die ersten Bitleitungen 8 sind unmittelbar über der Halbleiteroberfläche angeordnet. Die zweiten Bitleitungen 9 sind über die Halbleiteroberfläche angehoben und elektrisch von dem Halbleitermaterial isoliert, insbesondere von den oberen Source-/Draingebieten 5. Die zweiten Bitleitungen 9 können auch in Form von vergrabenen Bitleitungen realisiert sein, die die unteren Source-/Draingebiete 6 innerhalb der Halbleiterschicht oder des Substrats direkt verbinden. Die unteren Source-/Draingebiete 6 können Anteile von dotierten Gebieten darstellen, die als zweite Bitleitungen vorgesehen sind, die durchgehend entlang der Spalten des Speicherzellenarrays verlaufen. Die Wortleitungen 10 sind vorzugsweise über den Bitleitungen angeordnet und elektrisch von ihnen isoliert.

Figur 2 ist eine Draufsicht auf das Bauelement, das die Anordnung der Bitleitungen und Wortleitungen relativ zu den Vertiefungen zeigt, die die Speicherschichtfolgen und Gateelektroden umfassen. Die Speicherzellen sind in einem Zeilen und Spalten bildenden periodischen rechteckigen Raster angeordnet. In Figur 2 verlaufen die Spalten von links oben nach rechts unten, und die Zeilen verlaufen von links unten nach rechts oben. Die Speicherzellen sind durch konzentrische Kreise dargestellt, die die Gateelektrode 4, die umgebende Speicherschichtfolge 3, die an der zylindrischen Seitenwand der Vertiefung angeordnet ist, und das obere Source-/Draingebiet 5, das durch ein dotiertes Gebiet in der Halbleiterschicht oder im Substrat ausgebildet ist, bezeichnen. Die Stelle der unteren Source-/Draingebiete 6 ist in Figur 2 durch die breite Schraffierung im Bereich der beiden Zeilen von Speicherzellen angedeutet.

Die ersten Bitleitungen 8 kontaktieren die oberen Source-1/Draingebiete 5 von Speicherzellen zweier benachbarter Spalten in den Bereichen, die mit schmalen Schraffierungen in Figur 2 markiert sind. Zwischen den beiden ersten Bitleitungen 8 befindet sich eine zweite Bitleitung 9, die ebenfalls entlang einer Spalte angeordnet ist und elektrisch mit den unteren Source-/Draingebieten 6 der beiden benachbarten Spalten von Speicherzellen verbunden ist, die zu einem der disjunkten Paare von benachbarten Spalten gehören, in die das Speicherzellenarray unterteilt ist. Wenn die Konzentration von Dotierstoffatomen im unteren Source-/Draingebiet 6 hoch genug ist, dann reicht möglicherweise eine kleinere Anzahl von Kontaktplugs 6 entlang den zweiten Bitleitungen 9 aus, oder die unteren Source-/Draingebiete 6 können sogar vergrabene Bitleitungen bilden, die beispielsweise durchgehend durch den Bereich verlaufen können, der in Figur 2 durch die breite Schraffierung angedeutet ist. Es wird jedoch bevorzugt, die zweiten Bitleitungen 9 in Form von oberen Leiterbahnen mit einer Abfolge von Kontakten vorzusehen, die die unteren Source-/Draingebiete 6 über Kontaktplugs 7 kontaktieren. Statt dessen können die unteren Source-/Draingebiete 6 auf Gebiete beschränkt werden, die sich nur zu den benachbarten vier Vertiefungen erstrecken, deren Böden vollständig umgeben sein können, wie in den Figuren 1 und 2 gezeigt, wenngleich dies nicht notwendig ist. Die Vertiefungen brauchen keine zylindrische Form aufzuweisen. Somit kann der Oberflächenbereich, den jede Speicherzelle erfordert, so angepasst werden, dass man die größte Integrationsdichte erzielt.

Die relative Position der Bitleitungen und der Wortleitungen, die bei diesem Ausführungsbeispiel auf einer höheren Ebene angeordnet sind, ist in Figur 2 durch die gestrichelten Linien in den seitlichen Konturen der Bitleitungen in denjenigen Bereichen angedeutet, in denen die Bitleitungen von den Wortleitungen 10 bedeckt sind. Alle Komponenten des Bauelements, die in Figur 2 durch Kreise dargestellt sind, befinden sich unter den Bitleitungen, den Wortleitungen und dem elektrisch isolierenden dielektrischen Material, das als elektrische Isolierung oder Passivierung vorgesehen ist; dennoch sind diese Kreise in Figur 2 mit durchgehenden Linien gezeigt. Die Wortleitungen 10 sind parallel zueinander entlang den Zeilen des Speicherzellenarrays angeordnet. Die Breite der Bitleitungen und der Wortleitungen kann auf Abmessungen justiert werden, die in den Metallisierungsschichten technologisch realisiert werden können. Die seitlichen Abmessungen der Bitleitungen und der Wortleitungen differieren zwischen Figur 1 und Figur 2, um die Zeichnungen so klar wie möglich wiederzugeben, doch werden die Abmessungen nur durch die Anforderungen der Lithographie und der zwischen den Leiterbahnen erforderlichen elektrischen Isolierung eingeschränkt. Der Querschnitt nach Figur 1 ist in Figur 2 durch die gestrichelte und gekrümmte dicke Linie angedeutet, wobei die Blicklinie mit Pfeilen markiert ist. Die Kurve, entlang deren der Schnitt gezeichnet ist, erklärt die dreidimensionale perspektivische Ansicht der zylindrischen Gateelektrode auf der linken Seite von Figur 1 und des Kontaktplugs. Ein direkter Vergleich zwischen Figuren 1 und 2 verdeutlicht auch die perspektivische Ansicht der Schnitte der ersten und zweiten Bitleitungen und der Wortleitung in Figur 1, die nicht als Anteil des ebenen Querschnitts gezeichnet sind.

Die erfindungsgemäße Struktur der Charge-trapping-Speicherzellen bietet sich aufgrund der Unabhängigkeit der Kanallänge von der minimalen Strukturbreite F der prozessierten Chipfläche für das weitere Schrumpfen des Speicherzellenarrays an. Die Erfindung gestattet Bitdichten von mindestens 3F²/Bit. Die vertikale Gestalt der Transistorstruktur eliminiert die meisten der Seitenrandeffekte, die bei planaren Transistoren beobachtet werden, was zu einem homogeneren und vorhersagbareren Betriebsverhalten führt.

Wenngleich die vorliegende Erfindung und ihre Vorteile ausführlich beschrieben worden sind, versteht sich, dass im Rahmen der Erfindung, wie sie durch die beigefügten Ansprüche definiert ist, verschiedene Änderungen, Substitutionen und Abwandlungen vorgenommen werden können.

Bezugszeichenliste
- 1: Substrat
- 2: Vertiefung
- 3: Speicherschichtfolge
- 4: Gateelektrode
- 5: oberes Source-/Draingebiet
- 6: unteres Source-/Draingebiet
- 7: Kontaktplug
- 8: erste Bitleitung
- 9: zweite Bitleitung
- 10: Wortleitung

## Patentansprüche

1. Charge-trapping-Halbleiterspeicherbauelement mit
einer Halbleiterschicht oder einem Substrat (1) mit einer Hauptfläche mit einer Vertiefung (2), wobei sich die Vertiefung senkrecht zur Hauptfläche in die Halbleiterschicht oder das Substrat erstreckt und eine Seitenwand und einen Bodenbereich aufweist, der sich in einer größten Entfernung von der Hauptfläche befindet,
einer Speicherschichtfolge (3), die zumindest in einem Bereich der Seitenwand der Vertiefung angeordnet ist,
einer Gateelektrode (4), die in der Vertiefung angeordnet ist,
einem oberen Source-/Draingebiet (5), das an einem oberen Teil der Seitenwand neben der Hauptfläche angeordnet ist, einem unteren Source-/Draingebiet (6), das an einem unteren Teil der Seitenwand neben dem Bodenbereich angeordnet ist, und
Mitteln, die dafür vorgesehen sind, elektrische Spannungen an die Gateelektrode (4), das obere Source-/Draingebiet (5) und das untere Source-/Draingebiet (6) anzulegen.

2. Halbleiterspeicherbauelement nach Anspruch 1, bei dem
die Vertiefung (2) zylindrische Form hat, wobei der Bodenbereich flach oder abgerundet ist.

3. Halbleiterspeicherbauelement nach Anspruch 1 oder 2, bei dem die Mittel, die für das Anlegen elektrischer Spannungen vorgesehen sind, einen Kontaktplug (7) umfassen, der am unteren Source-/Draingebiet (6) angeordnet ist.

4. Halbleiterspeicherbauelement nach einem der Ansprüche 1 bis 3, bei dem
das obere Source-/Draingebiet (5) eine obere Grenzfläche aufweist, die innerhalb der Hauptfläche angeordnet ist.

5. Halbleiterspeicherbauelement nach einem der Ansprüche 1 bis 4, bei dem
ein Array von Vertiefungen (2) in der Halbleiterschicht oder dem Substrat (1) vorhanden ist, wobei jede Vertiefung mit einer Speicherschichtfolge (3), einer Gateelektrode (4), einem oberen Source-/Draingebiet (5) und einem unteren Source-/Draingebiet (6) versehen ist, wobei das Array Zeilen und Spalten umfasst,
ein Array von ersten Bitleitungen (8) vorhanden ist, die parallel zueinander angeordnet sind,
wobei jede erste Bitleitung (8) mit mehreren elektrischen Verbindungen zu mehreren der oberen Source-/Draingebiete (5) versehen ist, die entlang einer der Spalten angeordnet sind,
ein Array von zweiten Bitleitungen (9) vorhanden ist, die parallel zu den ersten Bitleitungen (8) angeordnet sind,
wobei jede zweite Bitleitung (9) mit mehreren elektrischen Verbindungen zu mehreren der unteren Source-/Draingebiete (6) versehen ist, die entlang einer der Spalten angeordnet sind, und
ein Array von Wortleitungen (10) vorhanden ist, die parallel zueinander angeordnet sind, wobei jede Wortleitung (10) mit mehreren elektrischen Verbindungen zu mehreren der Gateelektroden (4) versehen ist, die entlang einer der Zeilen angeordnet sind.

6. Halbleiterspeicherbauelement nach Anspruch 5, bei dem
das Array von Vertiefungen (2) disjunkte Paare benachbarter Spalten aufweist und
die unteren Source-/Draingebiete (6) jedes der Paare durch ein zusammenhängendes dotiertes Gebiet in der Halbleiterschicht oder dem Substrat ausgebildet sind.

7. Halbleiterspeicherbauelement nach Anspruch 6, bei dem
die zweiten Bitleitungen (9) jeweils für eines der Paare von benachbarten Spalten vorgesehen sind,
mehrere Kontaktplugs (7) für jede zweite Bitleitung (9) vorgesehen sind und
die Kontaktplugs (7) so angeordnet sind, dass sie das durchgehende dotierte Gebiet von unteren Source-/Draingebieten (6) in Bereichen kontaktieren, die zwischen vier zueinander benachbarten Vertiefungen (2) liegen.
